# EUROPÄISCHE PATENTSCHRIFT

(11) **EP 1 161 799 B1**
(45) Veröffentlichungstag und Bekanntmachung des Hinweises auf die Patenterteilung: **28.08.2002**
(21) Anmeldenummer: 00916789.1
(22) Anmeldetag: 01.03.2000
(51) Int. Cl.: H04B 1/40

(54) **SENDEEMPFÄNGER**
TRANSMITTER-RECEIVER
EMETTEUR-RECEPTEUR

(30) Priorität: 12.03.1999 DE 19911147
(43) Veröffentlichungstag der Anmeldung: 12.12.2001
(73) Patentinhaber: SIEMENS AKTIENGESELLSCHAFT, 80333 München (DE)
(72) Erfinder: MOLIERE, Thomas, D-80805 München (DE)
(86) Internationale Anmeldenummer: DE0000614
(87) Internationale Veröffentlichungsnummer: WO00055981

(56) Entgegenhaltungen:
- EP-A- 0 535 800
- US-A- 5 291 474

## Beschreibung

Die Erfindung bezieht sich auf einen Sendeempfänger mit einem HF-Empfänger, insbesondere UHF-Empfänger, mit digitaler Signalverarbeitung in einem Digitalteil, mit einem Eingangsteil, zumindest einem Mischer und einer Zwischenfrequenz/Basisbandverarbeitung sowie mit einem lokalen Kanaloszillator, dem ein erster Phasenregelkreis mit einem Phasendiskriminator und ein einstellbarer erster Frequenzumsetzer zugeordnet ist und mit einem Referenzoszillator für den Phasenregelkreis und den Steuertakt der digitalen Signalverarbeitung.

Bei vielen Funkgeräten und bei Funktelefonen im besonderen wird als Taktoszillator ein Quarzoszillator relativ niedriger Frequenz verwendet, dessen Oberwellen in das Empfangsband des Empfängers fallen können. US 5 291 474 offenbart ein derartiges Funlegerät.
GSM-Geräte arbeiten beispielsweise im 900 MHz-Band, wobei bei herkömmlichen Ausführungsformen der Empfänger eine Zwischenfrequenz von 45 - 400 MHz aufweist und der Sender mit Direktmodulation eines auf der Sendefrequenz des erzeugten Trägers arbeitet. Ein Kanaloszillator sowie ein Festfrequenzoszillator verwenden beide einen 13 MHz-Quarzoszillator als Referenz, wobei die Frequenz von 13 MHz deswegen verwendet wird, weil die zentral vom GSM-Digitalteil benötigte Taktfrequenz sich mit 13/6 = 2, 1666 MHz auf 13 MHz bezieht und aus ihr auch durch einfache Frequenzteilung die Kanalrasterfrequenz von 200 kHz hergeleitet wird, die gleich der Vergleichsfrequenz des Kanal-Synthesizers ist. Damit ist 13 MHz die niedrigste mögliche Referenzoszillator-Frequenz jedes konventionellen GSM-Telefons.

In dem angegebenen Beispiel fällt die zweiundsiebzigste Oberwelle des 13 MHz Oszillators in den Empfangskanal 936 MHz, und die dreiundsiebzigste Oberwelle in den Empfangskanal 949 MHz. Gerade bei den extrem miniaturisierten Mobiltelefonen ergibt sich durch die räumliche Nähe der Funkmodule zum Emp-MHz. Gerade bei den extrem miniaturisierten Mobiltelefonen ergibt sich durch die räumliche Nähe der Funkmodule zum Empfängereingang und zur Antenne ein besonderes Problem. Gängige Spezifikationen schreiben vor, daß störende Frequenzen am 50 Ohm-Empfängereingang beispielsweise unter 0,7 Mikrovolt liegen müssen. Ein üblicher 13 MHz Quarzoszillator schwingt mit einer Amplitude von ca. 1 Volt, was bedeutet, daß Oberwellen dieses Oszillators im Bereich 900 MHz um mehr als 120 dB gedämpft am Empfängereingang erscheinen dürfen. Die heute üblichen schnellen Siliziumtransistoren führen jedoch im 900 MHz-Bereich zu Oberwellenabständen von nur ca. 60 dB bezogen auf den Nutzträger. Somit ist eine zusätzliche Dämpfung zwischen Quarzoszillator und Empfängereingang von ca. 60 dB erforderlich. Bei den geringen räumlichen Abständen dieser Bereiche von höchstens 40 mm führt dies zu einem extremen Schirmaufwand in üblichen GSM-Mobiltelefonen, d. h. zur Verwendung von Blechteilen, Metallgehäusen, etc. Versuche, dieses Oberwellenproblem durch Schaltmaßnahmen alleine, z. B. durch Oberwellenfilter zu lösen, bringen nur Teilerfolge, da die Oberwellen dadurch im allgemeinen reflektiert und nicht vernichtet werden, was im Extremfall sogar dazu führen kann, daß kritische Oberwellen verstärkt abgestrahlt werden.

Eine Aufgabe der Erfindung liegt daher darin, einen Sendeempfänger zu schaffen, bei welchem das genannte Problem mit Oberwellen des Referenzoszillators dahingehend gelöst wird, daß Kosten, Volumen und Gewicht des Gerätes durch Wegfall oder Verringerung des Schirmaufwandes geringer werden.

Diese Aufgabe läßt sich mit einem Sendeempfänger der eingangs genannten Art lösen, bei welchem erfindungsgemäß zur Gewinnung des Steuertaktes ein digitaler Taktsynthesizer vorgesehen ist, dem ein Ausgangssignal des Referenzoszillators und ein Regelsignal von dem Digitalteil in Form eines digitalen Abstimmwortes zugeführt ist, wobei die Frequenz des Referenzoszillators so gewählt ist, daß ihre Größenordnung zumindest gleich der Bandbreite eines oder mehrerer der verwendeten Empfangsbänder beträgt und keine ihrer Oberwellen in einen Empfangskanal fällt.

Dank der Erfindung kann man leicht vermeiden, daß Oberwellen in einen Empfangskanal fallen, sodaß die Schirmung zwischen Sende- und Empfangsteil wesentlich verringert werden kann.

Bei einer besonders vorteilhaften Ausführungsform ist der Taktsynthesizer als Synthesizer mit direkter digitaler Synthese ausgebildet, da sich dadurch jede Frequenz aus einer beliebigen anderen Frequenz erzeugen läßt, und die Frequenz auch fein eingestellt werden kann.

Eine weitere vorteilhafte Ausbildung besitzt einen ersten Frequenzumsetzer, der ein Fraktional-N-Teiler mit Sigma-Delta-Modulator ist. Diese Ausführung bietet den Vorteil, daß sie schon bei konventionellem Aufbau schnelle Kanalwechsel, feine Abstimmschritte und gute Phasentauschwerte bei hohen Vergleichsfrequenzen erlaubt.

Zweckmäßigerweise wird dem ersten Frequenzumsetzer ein Feinabstimmungssignal von dem Digitalteil zugeführt, wodurch ein billigerer Referenzosziliator verwendet werden kann, der keine Feinabstimmung benötigt. Prinzipiell kann mit Vorteil allen verwendeten Frequenzumsetzern ein Feinabstimmungssignal zugeführt werden.

Eine andere zweckmäßige Fortbildung der Erfindung zeichnet sich dadurch aus, daß ein ZF-Oszillator vorgesehen ist, dem ein zweiter Phasenregelkreis mit einem Phasendiskriminator und einem zweiten Frequenzumsetzer zugeordnet ist, wobei dem Phasendiskriminator ein Ausgangssignal des Referenzoszillators und dem Frequenzumsetzer ein Modulationssignal sowie ein Feinabstimmsignal zugeführt ist. Dadurch läßt sich günstig ein moduliertes Signal aufbereiten. Dabei kann es vorteilhaft sein, wenn dem ZF-Oszillator ein GMSK-Modulationssignal eines fein einstellbaren Sigma-Delta-Synthesizers zugeführt ist.

Das Konzept nach der Erfindung ermöglicht die Verwendung sowohl eines konventionellen Heterodyn-Empfängers wie auch eines Homodyn-Empfängers, bei welchem einem Empfangsmischer das modulierte HF-Empfangssignal und mit jeweils dessen Frequenz ein Ausgangssignal des Kanalsynthesizers zugeführt ist, sodaß die Zwischenfrequenz dem Basisband entspricht.

Eine einfache und kostengünstige Verbindung zwischen Sender und Empfänger ergibt sich, wenn das modulierte Ausgangssignal des ZF-Oszillators und das Ausgangssignal eines Sendemischers einem Phasendiskriminator zugeführt sind, dem ein Signal eines gesteuerten Sendeoszillators sowie ein Ausgangssignal des lokalen Kanaloszillators zugeführt ist.

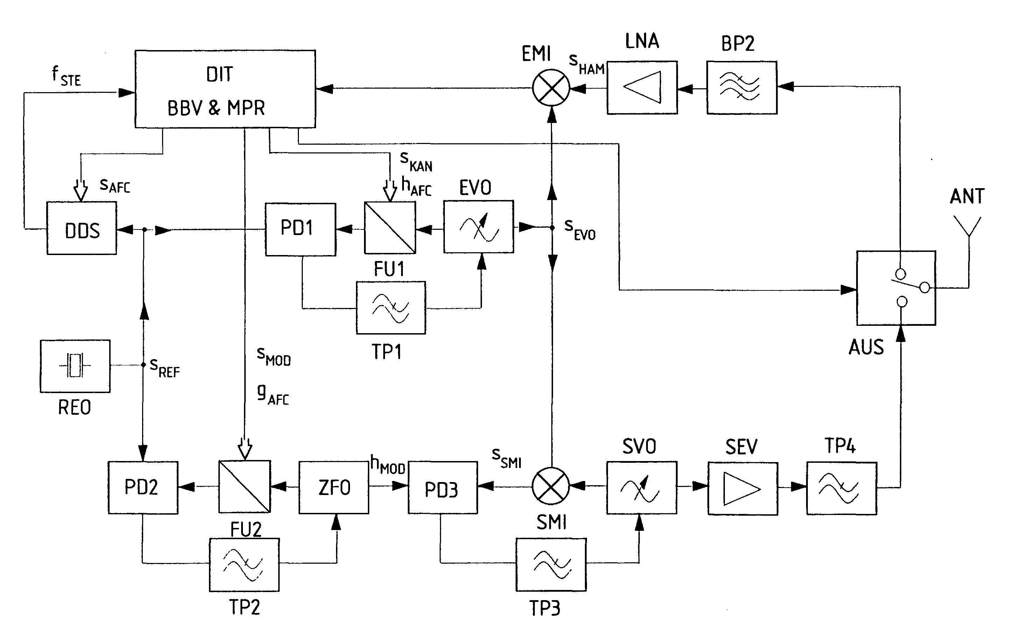

Die Erfindung samt weiterer Vorteile ist im folgenden anhand eines Ausführungsbeispiels näher erläutert, das in der Zeichnung dargestellt ist. In dieser zeigt die einzige Figur ein prinzipielles und vereinfachtes Blockschaltbild eines Sendeempfängers nach der Erfindung.

Gemäß der Zeichnung enthält ein Sendeempfänger gemäß der Erfindung eine Steuerung MPR und eine Basisbandverarbeitung BBV, die hier in einem einzigen, als Digitalteil DIT bezeichneten Block dargestellt sind. In bekannter Weise ist nun ein Referenzoszillator REO vorhanden, der ein Ausgangssignal S_{REF} liefert, und dieses Signal wird nun in der nachstehenden Weise zur Gewinnung eines Steuertaktes sowie zur Ableitung der für den Empfänger und Sender erforderlichen Kanalfrequenzen benützt. Das Ausgangssignal S_{REF} wird nun einem digitalen Synthesizer DDS zugeführt, der zweckmäßigerweise nach der digitalen direkten Synthese arbeitet. Derartige Synthesizer sind bekannt, und ein modernes Ausführungsbeispiel ist in der Firmenschrift CMOS, 125 MHz Complete DDS Synthesizer, AD 9850, Analog Devices, Inc. 1998, samt Schaltungsbeispielen und Funktionserläuterungen beschrieben. Für den vorliegenden Fall von besonderer Bedeutung ist es, daß ein solcher DDS-Synthesizer jede Frequenz aus einer beliebigen anderen Frequenz erzeugen kann, und auch eine Feineinstellung mit Hilfe eines AFC-Signals möglich ist, sodaß als Referenzoszillator billigere Oszillatoren beliebiger Frequenz, auch Keramikoszillatoren oder freilaufende Oszillatoren verwendet werden können. Referenzoszillatoren waren bis jetzt im Hinblick auf die geforderte Genauigkeit und Stabilität eines der teuersten Module von Funktelefonen.

Der Synthesizer DDS liefert einen Steuertakt f_{STE} an einen Microcontroller des Digitalteils DIT, wobei er aus diesem Block ein Regelsignal s_{AFC} erhält, nämlich in Form eines digitalen Abstimmwortes, das sowohl die Frequenzumsetzung bewirkt wie die Feinabstimmung auf die genaue Taktfrequenz, die mit Hilfe eines von der Basisstation empfangenen präzisen Taktes durchgeführt wird, nämlich in Form eines digitalen Abstimmwortes. Das Ausgangssignal S_{REF} des Referenzoszillators REO wird weiters einer PLL-Schleife zugeführt, die einen ersten Frequenzumsetzer FU1, einen Phasendiskriminator PD1, ein Tiefpaßfilter TP1 und einen lokalen Kanaloszillator EVO enthält. Der Frequenzumsetzer FU1 ist zweckmäßigerweise als Fraktional-N-Teiler mit Sigma-Delta-Modulator ausgeführt, und er erhält ein Feinabstimmsignal h_{AFC} sowie ein Kanalsignal S_{KAN} seitens des Mikroprozessorblocks MPR, BBV. Das Ausgangssignal des Kanaloszillators EVO gelangt empfängerseitig zu einem Empfängermischer EMI. Diesem Empfängermischer wird das Hochfrequenzsignal s_{HAM} zugeführt, welches über eine Antenne ANT mit einem steuerbaren Umschalter AUS, ein Bandpaßfilter BP2 und einen rauscharmen Verstärker LNA läuft. Zweckmäßigerweise und modernen Konzepten entsprechend wird direkt in das Basisband gemischt, d. h. die Frequenz des Mischoszillatorsignals entspricht immer genau der Frequenz des Hochfrequenzsignales s_{HAM}. Die Oszillatorfrequenz am Mischereingang kann gleich der direkten oder einer z. B. über einen Frequenzteiler umgesetzten Frequenz des Oszillators EVO sein. Nach diesem Prinzip arbeitende Empfänger werden bekanntlich als Homodyn-Empfänger bezeichnet. Eine eingehende Beschreibung eines Sigma-Delta-Fractional-N-Synthesizers findet sich in "Delta-Sigma Modulation in Fractional-N Frequency Synthesis", EEE Journal of Solid-State Circuits, Vol. 28, No. 5, May 1993, S. 553 - 559.

Senderseitig wird das Ausgangssignal S_{EVO} des Kanaloszillators EVO einem Sendermischer SMI zugeführt. Der Sendermischer ist in einer PLL-Schleife enthalten, die einen gesteuerten Sendeoszillator SVO, einen Phasendiskriminator PD3 sowie einen Tiefpaß TP3 enthält, und dem (dritten) Phasendiskriminator PD3 wird neben dem Ausgangssignal S_{SMI} des Mischers SMI auch ein Signal h_{MOD} zugeführt.

Das Signal h_{MOD} stellt das modulierte Ausgangssignal eines ZF-Ozillators ZFO dar, der gleichfalls in einer (zweiten) PLL-Schleife liegt, welche außerdem einen zweiten Frequenzumsetzer FU2, einen zweiten Phasendiskriminator PD2 und einen zweiten Tiefpaß TP2 enthält. Dem Frequenzumsetzer FU2 wird ein Modulationssignal S_{MOD} sowie ein Feinabstimmsignal g_{AFC} seitens des Mikroprozessor- und Basisbandblocks MPR, BBV zugeführt, und das Ausgangssignal des Frequenzumsetzers FU2 gelangt an einen Eingang des Phasendiskriminators PD2, dessen anderem Eingang das Ausgangssignal S_{REF} des Referenzoszillators REO zugeführt ist.

Immer noch senderseitig wird schließlich ein Ausgangssignal des gesteuerten Sendeoszillators SVO einem Sendeverstärker SEV und von hier über einen Tiefpaß TP4 dem Antennenumschalter AUS bzw. der Antenne ANT zugeführt.

Die Erfindung eignet sich besonders für Sendeempfänger, bei welchen die eingangs genannten Probleme hinsichtlich der Oberwellen von Bedeutung sind. Praktische Ausführungen haben sich für Funktelefone als zweckmäßig erwiesen, die im 900 bzw. 1800, 1900 und 2000 MHz-Bereich arbeiten, so bei den Systemen GSM 900, GSM 1800, GSM 1900 und IMT-2000 (UMTS). Bei sogenannten Multimode-Geräten kann es erforderlich sein, eine Referenzoszillator-Frequenz zu wählen, deren Oberwellen in keines der benutzten Empfangsbänder fallen.

## Patentansprüche

1. Sendeempfänger mit einem HF-Empfänger, insbesondere UHF-Empfänger, mit digitaler Signalverarbeitung in einem Digitalteil (DIT), mit einem Eingangsteil, zumindest einem Mischer und einer Zwischenfrequenz/Basisbandverarbeitung (BBV) sowie mit einem lokalen Kanaloszillator (EVO), dem ein erster Phasenregelkreis mit einem Phasendiskriminator (PD1) und ein einstellbarer erster Frequenzumsetzer zugeordnet ist und mit einem Referenzoszillator (REO) für den Phasenregelkreis und den Steuertakt (f_{ST}) der digitalen Signalverarbeitung,
**dadurch gekennzeichnet,**
**daß** zur Gewinnung des Steuertaktes (f_{STE}) ein digitaler Taktsynthesizer (DDS) vorgesehen ist, dem ein Ausgangssignal (S_{REF}) des Referenzoszillators (REO) und ein Regelsignal (S_{AFC}) von dem Digitalteil (DIT) in Form eines digitalen Abstimmwortes zugeführt ist, wobei die Frequenz (f_{REO}) des Referenzoszillators (REO) so gewählt ist, daß ihre Größenordnung zumindest gleich der Bandbreite eines oder mehrerer der verwendeten der Empfangsbänder beträgt und keine ihrer Oberwellen in einen Empfangskanal fällt.

2. Sendeempfänger nach Anspruch 1,
**dadurch gekennzeichnet, daß** der Taktsynthesizer (DDS) als Synthesizer mit direkter digitaler Synthese ausgebildet ist.

3. Sendeempfänger nach Anspruch 1 oder 2,
**dadurch gekennzeichnet, daß** der erste Frequenzumsetzer (FU1) ein DDs-Synthesizer oder ein Fractional-N-Teiler mit Sigma-Delta-Modulator ist.

4. Sendeempfänger nach einem der Ansprüche 1 bis 3,
**dadurch gekennzeichnet, daß** dem ersten Frequenzumsetzer (FU1) ein Feinabstimmungssignal (h_{AFC}) von dem Digitalteil (DIT) zugeführt ist.

5. Sendeempfänger nach einem der Ansprüche 1 bis 4,
**dadurch gekennzeichnet, daß** ein ZF-Oszillator (ZFO) vorgesehen ist, dem ein zweiter Phasenregelkreis mit einem Phasendiskriminator (PD2) und einem zweiten Frequenzumsetzer (FU2) zugeordnet ist, wobei dem Phasendiskriminator ein Ausgangssignal (s_{REF}) des Referenzoszillators (REO) und dem Frequenzumsetzer (FU2) ein Modulationssignal (s_{MOD}) sowie ein Feinabstimmsignal (g_{AFC}) von dem Digitalteil (DIT) zugeführt ist.

6. Sendeempfänger nach einem der Ansprüche 1 bis 5,
**dadurch gekennzeichnet, daß** der dem ZF-Oszillator (ZFO) zugeordnete Frequenzumsetzer (FU2) ein DDS-Synthesizer oder ein Fractional-N-Teiler mit Sigma-Delta-Modulator ist.

7. Sendeempfänger nach einem der Ansprüche 1 bis 6,
**dadurch gekennzeichnet, daß** dem feineinstellbaren ZF-Oszillator-Frequenzumsetzer (FU2) das Modulationssignal z. B. für eine GMSK-Modulation aus dem Digitalteil (DIT) zugeführt ist.

8. Sendeempfänger nach einem der Ansprüche 1 bis 7,
**dadurch gekennzeichnet, daß** das modulierte ZF-Signal mit Hilfe einer Frequenzumsetzung, Frequenzteilung oder DDS erzeugt ist.

9. Sendeempfänger nach einem der Ansprüche 1 bis 8,
**dadurch gekennzeichnet, daß** er als Homodyn-Empfänger ausgebildet ist, bei welchem einem Empfangsmischer (EMI) der modulierte HF-Träger (S_{HAM}) und mit jeweils dessen Frequenz ein direktes oder umgereihtes Ausgangssignal des Lokalen Kanaloszillators (EVO) zugeführt ist, sodaß die Zwischenfrequenz dem Basisband entspricht.

10. Sendeempfänger nach einem der Ansprüche 5 bis 9,
**dadurch gekennzeichnet, daß** das modulierte Ausgangssignal (h_{MOD}) des ZF-Oszillators (ZFO) und das Ausgangssignal eines Sendemischers (SMI) einem Phasendiskriminator (PD3) zugeführt sind, dem ein Signal eines gesteuerten Sendeoszillators (SVO) sowie ein Ausgangssignal (S_{EVO}) des lokalen Kanaloszillators (EVO) zugeführt ist.

## Claims

1. Transceiver having an RF receiver, in particular UHF receiver, with digital signal processing in a digital part (DIT), with an input part, at least one mixer and an intermediate frequency/baseband processing means (BBV), having a local channel oscillator (EVO) to which a first phase locked loop with a phase discriminator (PD1) and an adjustable first frequency converter are assigned, and having a reference oscillator (REO) for the phase locked loop and the control clock (f_{ST}) of the digital signal processing means, **characterized in that**, in order to acquire the control clock (f_{STE}), a digital clock synthesizer (DDS) is provided to which an upward signal (S_{REF}) of the reference oscillator (REO) is supplied, and a control signal (S_{AFC}) is supplied by the digital part (DIT) in the form of a digital tuning word, the frequency (f_{REO}) of the reference oscillator (REO) being selected such that its order of magnitude is at least equal to the bandwidth of one of more of the reception bands used and none of its harmonics occurs in a reception channel.

2. Transceiver according to Claim 1, **characterized in that** the clock synthesizer (DDS) is embodied as a synthesizer with direct digital synthesis.

3. Transceiver according to Claim 1 or 2, **characterized in that** the first frequency converter (FU1) is a DDS synthesizer or a fractional N divider with sigma-delta modulator.

4. Transceiver according to one of Claims 1 to 3, **characterized in that** a fine-tuning signal (h_{AFC}) issupplied to the first frequency converter (FU1) by the digital part (DIT).

5. Transceiver according to one of Claims 1 to 4, **characterized in that** an IF oscillator (ZFO) is provided to which a second phase locked loop with a phase discriminator (PD2) and a second frequency converter (FU2) is assigned, an output signal (S_{REF}) of the reference oscillator (REO) being supplied to the phase discriminator, and a modulation signal (S_{MOD}) and a fine-tuning signal (g_{AFC}) being supplied to the frequency converter (FU2) by the digital part (DIT).

6. Transceiver according to one of Claims 1 to 5, **characterized in that** the frequency converter (FU2) which is assigned to the IF oscillator (ZFO) is a DDS synthesizer or a fractional N divider with sigma-delta modulator.

7. Transceiver according to one of Claims 1 to 6, **characterized in that** the modulation signal, for example for GMSK modulation, is supplied to the finely adjustable IF oscillator frequency converter (FU2) from the digital part (DIT).

8. Transceiver according to one of Claims 1 to 7, **characterized in that** the modulated IF signal is generated using frequency conversion, frequency division or DDS.

9. Transceiver according to one of Claims 1 to 8, **characterized in that** it is embodied as a homodyne receiver in which the modulated RF carrier (S_{HAM}), and a direct or rearranged output signal, in each case with the frequency of said modulated RF carrier (S_{HAM}), of the local channel oscillator (EVO) are supplied to a reception mixer (EMI) so that the intermediate frequency corresponds to baseband.

10. Transceiver according to one of Claims 5 to 9, **characterized in that** the modulated output signal (h_{MOD}) of the IF oscillator (ZFO) and the output signal of a transmission mixer (SMI) are fed to a phase discriminator (PD3), to which a signal of a controlled transmission oscillator (SVO) and an output signal (S_{EVO}) of the local channel oscillator (EVO) are supplied.

## Revendications

1. Emetteur-récepteur avec un récepteur HF, notamment un récepteur UHF, avec dispositif de traitement numérique de signaux dans un élément numérique (DIT), avec un élément d'entrée, avec au moins un mélangeur et une fréquence intermédiaire/un dispositif de traitement de bande de base (BBV) ainsi qu'avec un oscillateur local (EVO), auquel sont attribués un premier circuit de réglage de phase ayant un discriminateur de phase (PD1) et un premier convertisseur de fréquence réglable, et avec un oscillateur de référence (REO) pour le circuit de réglage de phase et le rythme de commande (f_{ST}) du dispositif de traitement numérique de signaux,
**caractérisé en ce que**
un synthétiseur de rythme numérique (DDS) est prévu pour la récupération du rythme (f_{STE}), auquel synthétiseur sont amenés un signal de sortie (S_{REF}) de l'oscillateur de référence (REO) et un signal de réglage (S_{AFC}) de l'élément numérique (DIT) sous forme d'un mot d'accord numérique, la fréquence (f_{REO}) de l'oscillateur de référence (REO) étant sélectionnée de telle manière que son ordre de grandeur est au moins égal à la largeur de bande d'une bande ou de plusieurs des bandes de réception utilisées et qu'aucune de ses ondes harmoniques ne tombe dans un canal de réception.

2. Emetteur-récepteur selon la revendication 1,
**caractérisé en ce que** le synthétiseur de rythme (DDS) est formé comme synthétiseur à synthèse numérique directe.

3. Emetteur-récepteur selon la revendication 1 ou 2,
**caractérisé en ce que** le premier convertisseur de fréquence (FU1) est un synthétiseur DOS ou un diviseur fractionnaire N avec modulateur sigma delta.

4. Emetteur-récepteur selon l'une des revendications 1 à 3,
**caractérisé en ce qu'**un signal d'accord précis (h_{AFC}) de l'élément numérique (DIT) est amené au premier convertisseur de fréquence (FU1).

5. Emetteur-récepteur selon l'une des revendications 1 à 4,
**caractérisé en ce qu'**un oscillateur FI (ZFO) est prévu, auquel sont attribués un second circuit de réglage de phase ayant un discriminateur de phase (PD2) et un second convertisseur de fréquence (FU2), un signal de sortie (S_{REF}) de l'oscillateur de référence (REO) étant amené au discriminateur de phase et un signal de modulation (S_{MOD}) ainsi qu'un signal d'accord précis (g_{AFC}) de l'élément numérique (DIT) étant amenés au convertisseur de fréquence (FU2).

6. Emetteur-récepteur selon l'une des revendications 1 à 5, **caractérisé en ce que** le convertisseur de fréquence (FU2) attribué à l'oscillateur FI (ZFO) est un synthétiseur DDS ou un diviseur fractionnaire N avec modulateur sigma delta.

7. Emetteur-récepteur selon l'une des revendications 1 à 6,
**caractérisé en ce que** le signal de modulation est amené au convertisseur de fréquence (FU2) avec oscillateur FI à réglage de précision, p. ex. pour une modulation GMSK à partir de l'élément numérique (DIT).

8. Emetteur-récepteur selon l'une des revendications 1 à 7,
**caractérisé en ce que** le signal modulé FI est créé à l'aide d'une conversion de fréquence, d'une division de fréquence ou par DDS.

9. Emetteur-récepteur selon l'une des revendications 1 à 8,
**caractérisé en ce qu'**il est formé comme récepteur homodyne, dans lequel le porteur modulé HF (S_{HAM}) et un signal de sortie direct ou dérivé de l'oscillateur local (EVO), avec respectivement la fréquence de ce porteur, sont amenés à un mélangeur de réception (EMI), de sorte que la fréquence intermédiaire correspond à la bande de base.

10. Emetteur-récepteur selon l'une des revendications 5 à 9,
**caractérisé en ce que** le signal de sortie modulé (h_{MOD}) de l'oscillateur FI (ZFO) et le signal de sortie d'un mélangeur d'émission (SMI) sont amenés à un discriminateur de phase (PD3), auquel sont amenés un signal d'un oscillateur d'émission (SVO) asservi ainsi qu'un signal de sortie (S_{EVO}) de l'oscillateur local (EVO).
